# EUROPEAN PATENT APPLICATION

(11) **EP 3 876 088 A1**
(43) Date of publication of application: **08.09.2021**
(21) Application number: 20215678.2
(22) Date of filing: 18.12.2020
(51) Int. Cl.: G06F 3/06, G06F 1/3234, G06F 1/3225, G11C 16/00, G06F 12/02

(54) **NEGOTIATED POWER-UP FOR SSD DATA REFRESH**

(30) Priority: 06.03.2020 US 202016812026
(71) Applicant: INTEL Corporation, Santa Clara, CA 95054 (US)
(72) Inventor: TRIKA, Sanjeev, Santa Clara, CA California 95054 (US)
(74) Representative: Rummler, Felix

(57) **Abstract**

An embodiment of an electronic apparatus (10) may include one or more substrates, and logic (13) coupled to the one or more substrates, the logic (13) to manage a persistent storage media (12), provide a host with an indication of a time for the host to initiate a subsequent wake-up for data management of the persistent storage media, and perform data management of the persistent storage media in response to a host-initiated wake-up from a zero power state.

## Description

### BACKGROUND

A solid state drive (SSD) may have a variety of specifications including performance specifications, thermal specifications, and reliability/endurance specifications. Performance specifications include criteria such as input/output operations per second (IOPS), throughput / bandwidth, and latency. Reliability / endurance specifications include criteria such as drive writes per day, program/erase cycles, mean time between failure, and data retention. The data retention specification may refer to how long the SSD may keep uncorrupted data after the SSD is powered down.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1 is a block diagram of an example of an electronic system according to an embodiment;
FIG. 2 is a block diagram of an example of an electronic apparatus according to an embodiment;
FIGs. 3A to 3C are flowcharts of an example of a method of managing storage according to an embodiment;
FIG. 4 is an illustrative diagram of an example of a process flow according to an embodiment;
FIG. 5 is a block diagram of another example of a computing system according to an embodiment; and
FIG. 6 is a block diagram of an example of a solid state drive (SSD) device according to an embodiment.

### DETAILED DESCRIPTION

One or more embodiments or implementations are now described with reference to the enclosed figures. While specific configurations and arrangements are discussed, it should be understood that this is done for illustrative purposes only. Persons skilled in the relevant art will recognize that other configurations and arrangements may be employed without departing from the spirit and scope of the description. It will be apparent to those skilled in the relevant art that techniques and/or arrangements described herein may also be employed in a variety of other systems and applications other than what is described herein.

While the following description sets forth various implementations that may be manifested in architectures such as system-on-a-chip (SoC) architectures for example, implementation of the techniques and/or arrangements described herein are not restricted to particular architectures and/or computing systems and may be implemented by any architecture and/or computing system for similar purposes. For instance, various architectures employing, for example, multiple integrated circuit (IC) chips and/or packages, and/or various computing devices and/or consumer electronic (CE) devices such as set top boxes, smartphones, etc., may implement the techniques and/or arrangements described herein. Further, while the following description may set forth numerous specific details such as logic implementations, types and interrelationships of system components, logic partitioning/integration choices, etc., claimed subject matter may be practiced without such specific details. In other instances, some material such as, for example, control structures and full software instruction sequences, may not be shown in detail in order not to obscure the material disclosed herein.

The material disclosed herein may be implemented in hardware, firmware, software, or any combination thereof. The material disclosed herein may also be implemented as instructions stored on a machine-readable medium, which may be read and executed by one or more processors. A machine-readable medium may include any medium and/or mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g., carrier waves, infrared signals, digital signals, etc.), and others.

References in the specification to "one implementation", "an implementation", "an example implementation", etc., indicate that the implementation described may include a particular feature, structure, or characteristic, but every embodiment may not necessarily include the particular feature, structure, or characteristic. Moreover, such phrases are not necessarily referring to the same implementation. Further, when a particular feature, structure, or characteristic is described in connection with an embodiment, it is submitted that it is within the knowledge of one skilled in the art to effect such feature, structure, or characteristic in connection with other implementations whether or not explicitly described herein.

Various embodiments described herein may include a memory component and/or an interface to a memory component. Such memory components may include volatile and/or nonvolatile (NV) memory. Volatile memory may be a storage medium that requires power to maintain the state of data stored by the medium. Non-limiting examples of volatile memory may include various types of random access memory (RAM), such as dynamic RAM (DRAM) or static RAM (SRAM). One particular type of DRAM that may be used in a memory module is synchronous dynamic RAM (SDRAM). In particular embodiments, DRAM of a memory component may comply with a standard promulgated by Joint Electron Device Engineering Council (JEDEC), such as JESD79F for double data rate (DDR) SDRAM, JESD79-2F for DDR2 SDRAM, JESD79-3F for DDR3 SDRAM, JESD79-4A for DDR4 SDRAM, JESD209 for Low Power DDR (LPDDR), JESD209-2 for LPDDR2, JESD209-3 for LPDDR3, and JESD209-4 for LPDDR4 (these standards are available at jedec.org). Such standards (and similar standards) may be referred to as DDR-based standards and communication interfaces of the storage devices that implement such standards may be referred to as DDR-based interfaces.

NV memory (NVM) may be a storage medium that does not require power to maintain the state of data stored by the medium. In one embodiment, the memory device may include a block addressable memory device, such as those based on NAND or NOR technologies. A memory device may also include future generation nonvolatile devices, such as a three dimensional (3D) crosspoint memory device, or other byte addressable write-in-place nonvolatile memory devices. In one embodiment, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor RAM (FeTRAM), anti-ferroelectric memory, magnetoresistive RAM (MRAM) memory that incorporates memristor technology, resistive memory including the metal oxide base, the oxygen vacancy base and the conductive bridge RAM (CB-RAM), or spin transfer torque (STT)-MRAM, a spintronic magnetic junction memory based device, a magnetic tunneling junction (MTJ) based device, a DW (Domain Wall) and SOT (Spin Orbit Transfer) based device, a thyristor based memory device, or a combination of any of the above, or other memory. The memory device may refer to the die itself and/or to a packaged memory product. In particular embodiments, a memory component with non-volatile memory may comply with one or more standards promulgated by the JEDEC, such as JESD218, JESD219, JESD220-1, JESD223B, JESD223-1, or other suitable standard (the JEDEC standards cited herein are available at jedec.org).

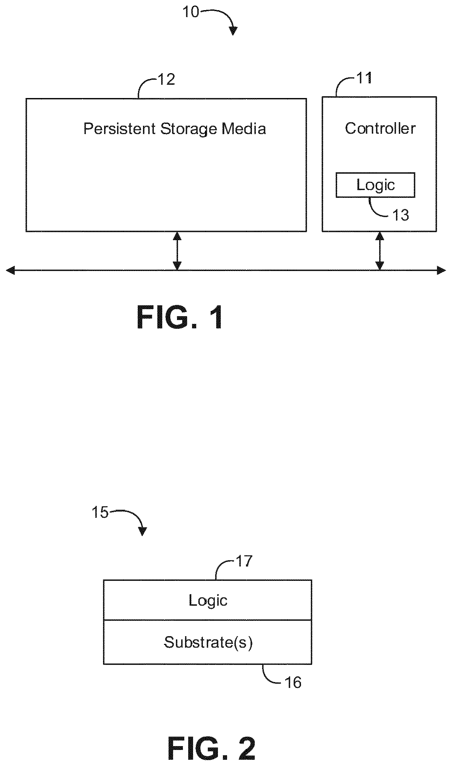

With reference to FIG. 1, an embodiment of an electronic system 10 may include persistent storage media 12 and a controller 11 communicatively coupled to the persistent storage media 12. The controller 11 may include logic 13 to manage the persistent storage media 12, provide a host with an indication of a time for the host to initiate a subsequent wake-up for data management of the persistent storage media 12, and perform data management of the persistent storage media 12 in response to a host-initiated wake-up from a zero power state. In some embodiments, the data management may correspond to data retention management. For example, the logic 13 may be configured to provide the host with the indication of the time for the host to initiate the subsequent wake-up in response to the host-initiated wake-up from the zero power state.

In some embodiments, the logic 13 may be configured to provide the host with an indication of a time interval for the host to initiate the subsequent wake-up in response to an information query from the host. For example, the time interval may correspond to an amount of time after a removal of power to the persistent storage media 12. In some embodiments, the logic 13 may be further configured to provide a shutdown request to the host after the data management of the persistent storage media 12 is performed. In some embodiments, the logic 13 may also be configured to remove power to the persistent storage media 12 in response to a shutdown request from the host, and provide the host with an indication of a time interval for the host to initiate the subsequent wake-up in response to the shutdown request. Additionally, or alternatively, the logic 13 may be configured to proactively inform the host of any updated wake-up time requirements. For example, the logic 13 may support a device-initiated update of the wake-up time or time interval may be provided to the host which is not in response to any external event. In any of the embodiments herein, the persistent storage media 12 may comprise a solid state drive (SSD).

Embodiments of each of the above controller 11, persistent storage media 12, logic 13, and other system components may be implemented in hardware, software, or any suitable combination thereof. For example, hardware implementations may include configurable logic such as, for example, programmable logic arrays (PLAs), field programmable gate arrays (FPGAs), complex programmable logic devices (CPLDs), or fixed-functionality logic hardware using circuit technology such as, for example, application specific integrated circuit (ASIC), complementary metal oxide semiconductor (CMOS) or transistor-transistor logic (TTL) technology, or any combination thereof. Embodiments of the controller 11 may include a general purpose controller, a special purpose controller, a storage controller, a memory controller, a micro-controller, a general purpose processor, a special purpose processor, a central processor unit (CPU), an execution unit, etc. In some embodiments, the persistent storage media 12, the logic 13, and/or other system memory may be located in, or co-located with, various components, including the controller 11 (e.g., on a same die).

Alternatively, or additionally, all or portions of these components may be implemented in one or more modules as a set of logic instructions stored in a machine- or computer-readable storage medium such as random access memory (RAM), read only memory (ROM), programmable ROM (PROM), firmware, flash memory, etc., to be executed by a processor or computing device. For example, computer program code to carry out the operations of the components may be written in any combination of one or more operating system (OS) applicable/appropriate programming languages, including an object-oriented programming language such as PYTHON, PERL, JAVA, SMALLTALK, C++, C# or the like and conventional procedural programming languages, such as the "C" programming language or similar programming languages. For example, the persistent storage media 12, other persistent storage media, or other system memory may store a set of instructions which when executed by the controller 11 cause the system 10 to implement one or more components, features, or aspects of the system 10 (e.g., the logic 13, managing the persistent storage media 12, providing the host with the indication of the time for the host to initiate a subsequent wake-up for data management of the persistent storage media 12, performing data management of the persistent storage media 12 in response to the host-initiated wake-up from the zero power state, etc.).

Turning now to FIG. 2, an embodiment of an electronic apparatus 15 may include one or more substrates 16, and logic 17 coupled to the one or more substrates 16. The logic 17 may be configured to manage a persistent storage media, provide a host with an indication of a time for the host to initiate a subsequent wake-up for data management of the persistent storage media, and perform data management of the persistent storage media in response to a host-initiated wake-up from a zero power state. In some embodiments, the data management may correspond to data retention management. For example, the logic 17 may be configured to provide the host with the indication of the time for the host to initiate the subsequent wake-up in response to the host-initiated wake-up from the zero power state.

In some embodiments, the logic 17 may be configured to provide the host with an indication of a time interval for the host to initiate the subsequent wake-up in response to an information query from the host. For example, the time interval may correspond to an amount of time after a removal of power to the persistent storage media. In some embodiments, the logic 17 may be further configured to provide a shutdown request to the host after the data management of the persistent storage media is performed. In some embodiments, the logic 17 may also be configured to remove power to the persistent storage media in response to a shutdown request from the host, and provide the host with an indication of a time interval for the host to initiate the subsequent wake-up in response to the shutdown request. Additionally, or alternatively, the logic 17 may be configured to proactively inform the host of any updated wake-up time requirements. For example, the logic 17 may support a device-initiated update of the wake-up time or time interval may be provided to the host which is not in response to any external event. In any of the embodiments herein, the persistent storage media may comprise a SSD.

Embodiments of the logic 17 may be implemented in a system, apparatus, computer, device, etc., for example, such as those described herein. More particularly, hardware implementations of the logic 17 may include configurable logic such as, for example, PLAs, FPGAs, CPLDs, or in fixed-functionality logic hardware using circuit technology such as, for example, ASIC, CMOS, or TTL technology, or any combination thereof. Alternatively, or additionally, the logic 17 may be implemented in one or more modules as a set of logic instructions stored in a machine- or computer-readable storage medium such as RAM, ROM, PROM, firmware, flash memory, etc., to be executed by a processor or computing device. For example, computer program code to carry out the operations of the components may be written in any combination of one or more OS applicable/appropriate programming languages, including an object-oriented programming language such as PYTHON, PERL, JAVA, SMALLTALK, C++, C# or the like and conventional procedural programming languages, such as the "C" programming language or similar programming languages.

For example, the logic 17 may be implemented on a semiconductor apparatus, which may include the one or more substrates 16, with the logic 17 coupled to the one or more substrates 16. In some embodiments, the logic 17 may be at least partly implemented in one or more of configurable logic and fixed-functionality hardware logic on semiconductor substrate(s) (e.g., silicon, sapphire, gallium-arsenide, etc.). For example, the logic 17 may include a transistor array and/or other integrated circuit components coupled to the substrate(s) 16 with transistor channel regions that are positioned within the substrate(s) 16. The interface between the logic 17 and the substrate(s) 16 may not be an abrupt junction. The logic 17 may also be considered to include an epitaxial layer that is grown on an initial wafer of the substrate(s) 16.

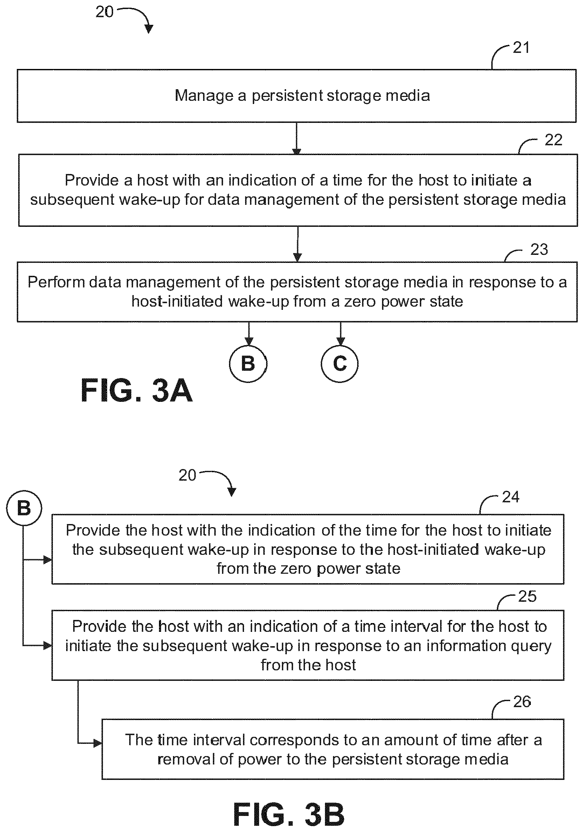

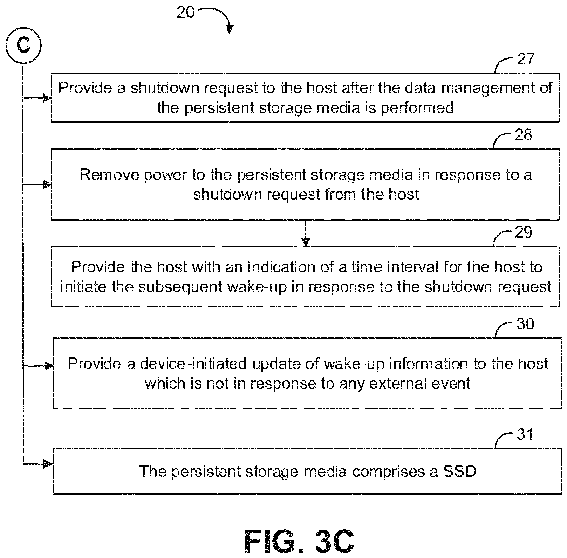

Turning now to FIGs. 3A to 3C, an embodiment of a method 20 of managing storage may include managing a persistent storage media at block 21, providing a host with an indication of a time for the host to initiate a subsequent wake-up for data management of the persistent storage media at block 22, and performing data management of the persistent storage media in response to a host-initiated wake-up from a zero power state at block 23. In some embodiments, the data management may correspond to data retention management. For example, the method 20 may include providing the host with the indication of the time for the host to initiate the subsequent wake-up in response to the host-initiated wake-up from the zero power state at block 24.

In some embodiments, the method 20 may further include providing the host with an indication of a time interval for the host to initiate the subsequent wake-up in response to an information query from the host at block 25. For example, the time interval may correspond to an amount of time after a removal of power to the persistent storage media at block 26. Some embodiments of the method 20 may also include providing a shutdown request to the host after the data management of the persistent storage media is performed at block 27. Some embodiments of the method 20 may also include removing power to the persistent storage media in response to a shutdown request from the host at block 28, and providing the host with an indication of a time interval for the host to initiate the subsequent wake-up in response to the shutdown request at block 29. Additionally, or alternatively, the method 20 include proactively informing the host of any updated wake-up time requirements. For example, the method 20 may include providing a device-initiated update of wake-up information (e.g., the wake-up time, time interval, etc.) to the host which is not in response to any external event at block 30. In any of the embodiments herein, the persistent storage media may comprise a SSD at block 31.

Embodiments of the method 20 may be implemented in a system, apparatus, computer, device, etc., for example, such as those described herein. More particularly, hardware implementations of the method 20 may include configurable logic such as, for example, PLAs, FPGAs, CPLDs, or in fixed-functionality logic hardware using circuit technology such as, for example, ASIC, CMOS, or TTL technology, or any combination thereof. Alternatively, or additionally, the method 20 may be implemented in one or more modules as a set of logic instructions stored in a machine- or computer-readable storage medium such as RAM, ROM, PROM, firmware, flash memory, etc., to be executed by a processor or computing device. For example, computer program code to carry out the operations of the components may be written in any combination of one or more OS applicable/appropriate programming languages, including an object-oriented programming language such as PYTHON, PERL, JAVA, SMALLTALK, C++, C# or the like and conventional procedural programming languages, such as the "C" programming language or similar programming languages.

For example, the method 20 may be implemented on a computer readable medium as described in connection with Examples 22 to 28 below. Embodiments or portions of the method 20 may be implemented in firmware, applications (e.g., through an application programming interface (API)), or driver software running on an operating system (OS). Additionally, logic instructions might include assembler instructions, instruction set architecture (ISA) instructions, machine instructions, machine dependent instructions, microcode, state-setting data, configuration data for integrated circuitry, state information that personalizes electronic circuitry and/or other structural components that are native to hardware (e.g., host processor, central processing unit/CPU, microcontroller, etc.).

Some embodiments may advantageously provide technology for a negotiated power-up for data refresh on SSDs. In datacenters, for example, cold storage use cases require data on media to have high retention (e.g., minimally 5 years). SSD media such as NAND media, however, has much lower retention (e.g., typically days/months). For warm/hot use-cases, a SSD may manage data retention via periodic data refresh/relocation which requires the drive to perform significant input/output (I/O) in the background (e.g., relocating the entire drive's content every few days). For warm/hot use cases, the SSD may remain powered-up for the purpose of data retention management, where the idle state may consume several watts of power. For a cold storage use case, it may be preferred that the drive consumes zero (0) power when idle. Accordingly, problems with utilizing conventional SSD technology for cold storage include non-zero power utilization when idle and/or the host not being aware of or configured to manage various time constraints for SSD data refresh. Advantageously, some embodiments may overcome one or more of the foregoing problems with conventional SSD technology. For example, some embodiments may provide a SSD device that goes to zero power when idle, but also powers-up and performs data relocations when required to maintain retention, even when no host I/O is necessary.

Some embodiments may provide technology for a SSD to negotiate a wake-up frequency with a host, and also later request shutdown. The host may then power-up the SSD at the pre-negotiated time. When awake, the SSD may subsequently perform the internal media management operations, and then request a shutdown. Such shutdown requests initiated by the SSD may optionally specify a duration after which the SSD expects the hosts to wake the SSD up again. Embodiments may be implemented in HIPM (host-initiated power-management) techniques and/or DIPM (device-initiated power management) techniques. A suitably configured SSD may be utilized together with a host platform to enable low-cost, high capacity NAND SSDs to be advantageously used for cold storage, which demands high retention yet zero idle power.

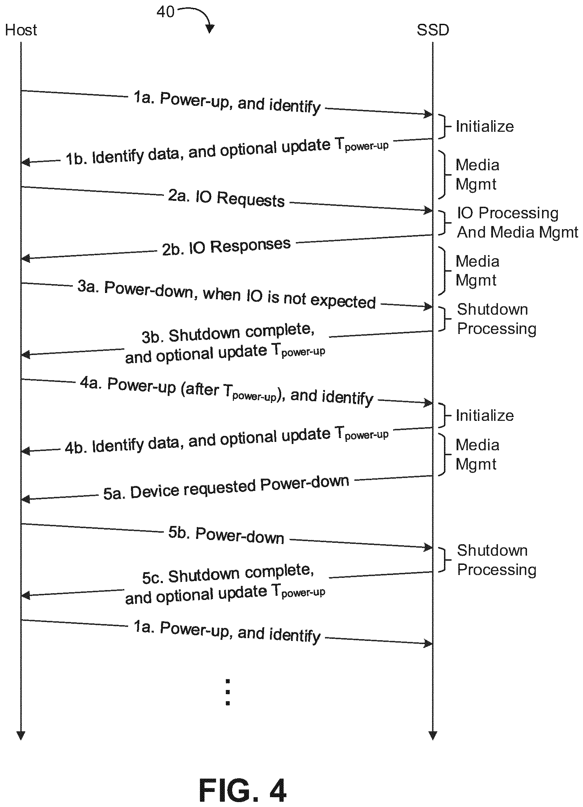

With reference to FIG. 4, an embodiment of a process flow 40 for managing a SSD shows host actions on one side and SSD actions on the other side, where time increases vertically downwards. At arrow 1a, the host powers-up the SSD, and performs 'identify' type operations that help the host detect the device characteristics (e.g., capacity, number of namespaces, etc.). The SSD initializes and for one of the responses, at arrow 1b, the SSD provides a value to the host that requests the host to power-up the device T_{power-up} seconds after any shutdown of the SSD. In some embodiments, the T_{power-up} update may be implemented via an extension to an identify command/response. Additionally, or alternatively, a new command may be implemented to provide the T_{power-up} update. Arrows 2a and 2b show how the host and the SSD may perform I/O and other operations (e.g., trim, admin-commands etc.). The SSD may perform media management at all times that the SSD is awake. When the SSD is powered up, as shown in between arrows 1a, 1b, arrows 2a, 2b, and arrow 3a, the SSD may perform media management operations including data retention management. Similarly, the SSD may perform media management in other time segments when the SSD is not shut-off.

In some embodiments, as illustrated at arrow 3a, the host can shut down the SSD based on conventional storage management technology (e.g., HIPM techniques), or if no I/O operations are expected for an extended amount of time. As part of shutdown completion, as illustrated at arrow3b, the SSD may send an updated T_{power-up} value to the host. In some embodiments, the T_{power-up} update may be implemented via an extension to a shutdown command/response pair. Additionally, or alternatively, a new command that precedes shutdown may be implemented to provide the T_{power-up} update.

At arrow 4a, the host powers-up the SSD within T_{power-up} seconds of last shutdown, regardless of whether it needs to do I/O or other operations. For example, the host may utilize timers, counters or any conventional time/event management technology to keep track of when such a host-initiated power-up should be executed. Because the SSD receives this as a power-up, the SSD may provide an updated T_{power-up} value at arrow 4b. The SSD then performs the media management operations (e.g., including data relocation/refresh) as needed to provide the retention characteristics of the SSD. After the SSD has completed the media management operations, and if there have been no host I/O in the meantime, the SSD may request the host to shut the SSD down at arrow 5a. For example, the device-initiated shutdown may be implemented using DIPM techniques. At arrow 5b, the host sends the shutdown request to the SSD and, at arrow 5c, the SSD may provide an updated T_{power-up} value to the host at this time (e.g., using command extensions or new commands).

Those skilled in the art will appreciate that the process flow 40 is just one example provided for the purpose of explanation and not limitation. For example, the SSD may proactively provide an updated T_{power-up} value to the host which is not in response to a host-initiated event. For example, reliability and/or endurance characteristics of the SSD may change over time. Such changes may be detected or determined by the SSD (e.g., during media management), which may cause the SSD to update the T_{power-up} value and provide the updated value to the host. In another example, the SSD may recognize that it has not received I/O for a time-period (e.g., which may be fixed or dynamically set), and request the host to shut the SSD down pro-actively (e.g., arrow 3a may be SSD-initiated via a pre-step notification to the host). Given the benefit of the present specification and drawings, numerous other examples will occur to those skilled in the art.

The technology discussed herein may be provided in various computing systems (e.g., including a non-mobile computing device such as a desktop, workstation, server, rack system, etc., a mobile computing device such as a smartphone, tablet, Ultra-Mobile Personal Computer (UMPC), laptop computer, ULTRABOOK computing device, smart watch, smart glasses, smart bracelet, etc., and/or a client/edge device such as an Internet-of-Things (IoT) device (e.g., a sensor, a camera, etc.)).

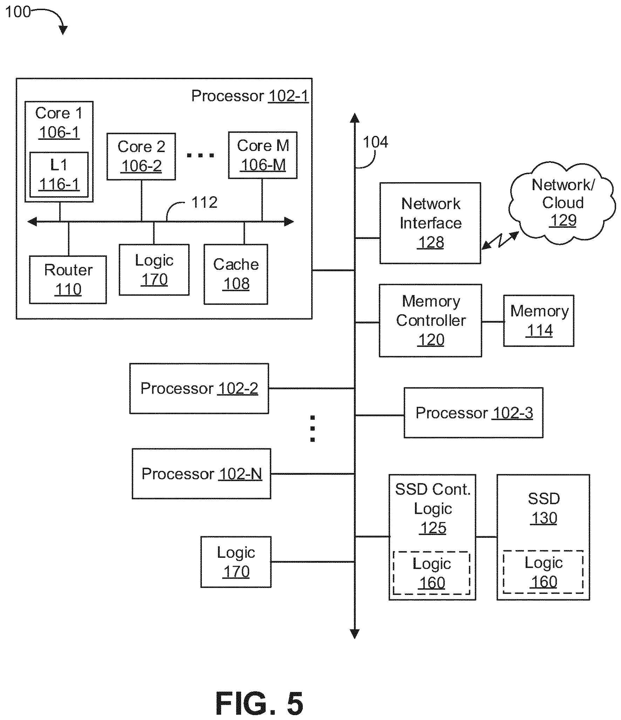

Turning now to FIG. 5, an embodiment of a computing system 100 may include one or more processors 102-1 through 102-N (generally referred to herein as "processors 102" or "processor 102"). The processors 102 may communicate via an interconnection or bus 104. Each processor 102 may include various components some of which are only discussed with reference to processor 102-1 for clarity. Accordingly, each of the remaining processors 102-2 through 102-N may include the same or similar components discussed with reference to the processor 102-1.

In some embodiments, the processor 102-1 may include one or more processor cores 106-1 through 106-M (referred to herein as "cores 106," or more generally as "core 106"), a cache 108 (which may be a shared cache or a private cache in various embodiments), and/or a router 110. The processor cores 106 may be implemented on a single integrated circuit (IC) chip. Moreover, the chip may include one or more shared and/or private caches (such as cache 108), buses or interconnections (such as a bus or interconnection 112), logic 170, memory controllers, or other components.

In some embodiments, the router 110 may be used to communicate between various components of the processor 102-1 and/or system 100. Moreover, the processor 102-1 may include more than one router 110. Furthermore, the multitude of routers 110 may be in communication to enable data routing between various components inside or outside of the processor 102-1.

The cache 108 may store data (e.g., including instructions) that is utilized by one or more components of the processor 102-1, such as the cores 106. For example, the cache 108 may locally cache data stored in a memory 114 for faster access by the components of the processor 102. As shown in FIG. 5, the memory 114 may be in communication with the processors 102 via the interconnection 104. In some embodiments, the cache 108 (that may be shared) may have various levels, for example, the cache 108 may be a mid-level cache and/or a last-level cache (LLC). Also, each of the cores 106 may include a level 1 (L1) cache (116-1) (generally referred to herein as "L1 cache 116"). Various components of the processor 102-1 may communicate with the cache 108 directly, through a bus (e.g., the bus 112), and/or a memory controller or hub.

As shown in FIG. 5, memory 114 may be coupled to other components of system 100 through a memory controller 120. Memory 114 may include volatile memory and may be interchangeably referred to as main memory or system memory. Even though the memory controller 120 is shown to be coupled between the interconnection 104 and the memory 114, the memory controller 120 may be located elsewhere in system 100. For example, memory controller 120 or portions of it may be provided within one of the processors 102 in some embodiments.

The system 100 may communicate with other devices/systems/networks via a network interface 128 (e.g., which is in communication with a computer network and/or the cloud 129 via a wired or wireless interface). For example, the network interface 128 may include an antenna (not shown) to wirelessly (e.g., via an Institute of Electrical and Electronics Engineers (IEEE) 802.11 interface (including IEEE 802.1 1a/b/g/n/ac, etc.), cellular interface, 3G, 4G, LTE, BLUETOOTH, etc.) communicate with the network/cloud 129.

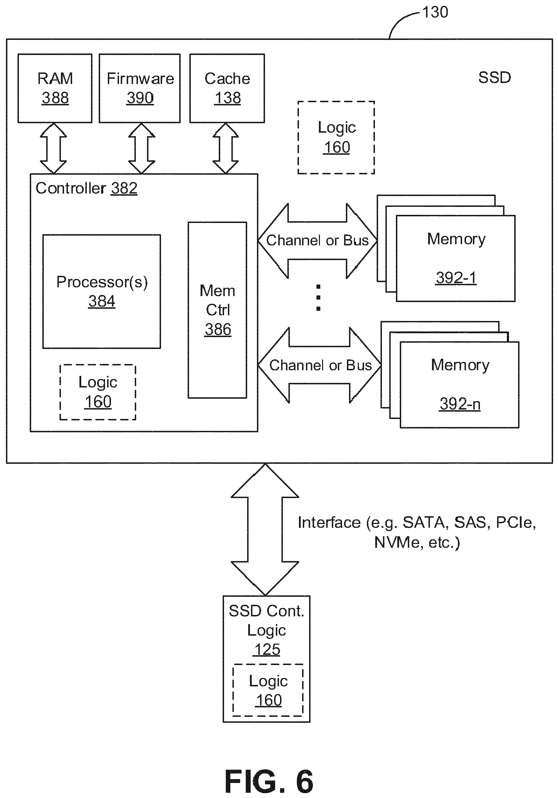

System 100 may also include a storage device such as a SSD device 130 coupled to the interconnect 104 via SSD controller logic 125. Hence, logic 125 may control access by various components of system 100 to the SSD device 130. Furthermore, even though logic 125 is shown to be directly coupled to the interconnection 104 in FIG. 5, logic 125 can alternatively communicate via a storage bus/interconnect (such as the SATA (Serial Advanced Technology Attachment) bus, Peripheral Component Interconnect (PCI) (or PCI EXPRESS (PCIe) interface), NVM EXPRESS (NVMe), etc.) with one or more other components of system 100 (for example where the storage bus is coupled to interconnect 104 via some other logic like a bus bridge, chipset, etc.) Additionally, logic 125 may be incorporated into memory controller logic (such as those discussed with reference to FIG. 6) or provided on a same integrated circuit (IC) device in various embodiments (e.g., on the same circuit board device as the SSD device 130 or in the same enclosure as the SSD device 130).

Furthermore, logic 125 and/or SSD device 130 may be coupled to one or more sensors (not shown) to receive information (e.g., in the form of one or more bits or signals) to indicate the status of or values detected by the one or more sensors. These sensor(s) may be provided proximate to components of system 100 (or other computing systems discussed herein), including the cores 106, interconnections 104 or 112, components outside of the processor 102, SSD device 130, SSD bus, SATA bus, logic 125, logic 160, logic 170, etc., to sense variations in various factors affecting power/thermal behavior of the system/platform, such as temperature, operating frequency, operating voltage, power consumption, and/or inter-core communication activity, etc.

FIG. 6 illustrates a block diagram of various components of the SSD device 130, according to an embodiment. As illustrated in FIG. 6, logic 160 may be located in various locations such as inside the SSD device 130 or controller 382, etc., and may include similar technology as discussed in connection with FIG. 5. The SSD device 130 includes a controller 382 (which in turn includes one or more processor cores or processors 384 and memory controller logic 386), cache 138, RAM 388, firmware storage 390, and one or more memory devices 392-1 to 392-N (collectively memory 392, which may include 3D crosspoint, or other types of non-volatile memory). The memory 392 is coupled to the memory controller logic 386 via one or more memory channels or busses. Also, SSD device 130 communicates with logic 125 via an interface (such as a SATA, SAS, PCIe, NVMe, etc., interface). Processors 384 and/or controller 382 may compress/decompress data written to or read from memory devices 392-1 to 392-N.

As illustrated in FIGs. 5 and 6, the SSD device 130 may include logic 160, which may be in the same enclosure as the SSD device 130 and/or fully integrated on a printed circuit board (PCB) of the SSD device 130. The system 100 may include further logic 170 outside of the SSD device 130. One or more of the features/aspects/operations discussed with reference to FIGs. 1-4 may be performed by one or more of the components of FIGs. 5 and/or 6. Also, one or more of the features/aspects/ operations of FIGs. 1-4 may be programmed into the firmware 390. Further, SSD controller logic 125 may also include logic 160. Advantageously, the logic 160 and/or logic 170 may include technology to implement one or more aspects of the system 10 (FIG. 1), the apparatus 15 (FIG. 2), the method 20 (FIGs. 3A to 3C), the process flow 40 (FIG. 4 and/or any of the features discussed herein. For example, the logic 170 may include technology to implement the host device/computer system/agent aspects of the various embodiments described herein while the logic 160 may include technology to implement the storage device aspects of the various embodiments described herein.

In particular, the logic 160 may be configured to manage the SSD 130, provide a host processor 102 with an indication of a time for the host processor 102 to initiate a subsequent wake-up for data management of the SSD 130, and perform data management of the SSD 130 in response to a host-initiated wake-up from a zero power state. In some embodiments, the data management may correspond to data retention management. For example, the logic 160 may be configured to provide the host processor 102 with the indication of the time for the host processor 102 to initiate the subsequent wake-up in response to the host-initiated wake-up from the zero power state. The logic 170 may be configured to track/monitor the time since the shutdown of the SSD 130 and cause the host processor 102 to power-up the SSD 130 in accordance with the indication of the time provided by the logic 160.

In some embodiments, the logic 160 may be configured to provide the host processor 102 with an indication of a time interval for the host processor 102 to initiate the subsequent wake-up in response to an information query from the host processor 102. For example, the time interval may correspond to an amount of time after a removal of power to the SSD 130. In some embodiments, the logic 160 may be further configured to provide a shutdown request to the host processor 102 after the data management of the SSD 130 is performed. In some embodiments, the logic 160 may also be configured to remove power to the SSD 130 in response to a shutdown request from the host processor 102, and provide the host processor 102 with an indication of a time interval for the host processor 102 to initiate the subsequent wake-up in response to the shutdown request. Additionally, or alternatively, the logic 13 may be configured to proactively inform the host processor 102 of any updated wake-up time requirements. For example, the logic 160 may support a device-initiated update of the wake-up time or time interval may be provided to the host processor 102 which is not in response to any external event.

In other embodiments, the SSD device 130 may be replaced with any suitable storage/memory technology/media. In some embodiments, the logic 160/170 may be coupled to one or more substrates (e.g., silicon, sapphire, gallium arsenide, printed circuit board (PCB), etc.), and may include transistor channel regions that are positioned within the one or more substrates. In other embodiments, the SSD device 130 may include two or more types of storage media. For example, the bulk of the storage may be NAND and may further include some faster, smaller granularity accessible (e.g., byte-addressable) NVM such as INTEL 3DXP media. The SSD device 130 may alternatively, or additionally, include persistent volatile memory (e.g., battery or capacitor backed-up DRAM or SRAM). For example, the SSD device 130 may include POWER LOSS IMMINENT (PLI) technology with energy storing capacitors. The energy storing capacitors may provide enough energy (power) to complete any commands in progress and to make sure that any data in the DRAMs/SRAMs is committed to the non-volatile NAND media. The capacitors may act as backup batteries for the persistent volatile memory. As shown in FIG. 5, features or aspects of the logic 160 and/or the logic 170 may be distributed throughout the system 100, and/or co-located/integrated with various components of the system 100.

### Additional Notes and Examples

Example 1 includes an electronic apparatus, comprising one or more substrates, and logic coupled to the one or more substrates, the logic to manage a persistent storage media, provide a host with an indication of a time for the host to initiate a subsequent wake-up for data management of the persistent storage media, and perform data management of the persistent storage media in response to a host-initiated wake-up from a zero power state.
Example 2 includes the apparatus of Example 1, wherein the logic is further to provide the host with the indication of the time for the host to initiate the subsequent wake-up in response to the host-initiated wake-up from the zero power state.
Example 3 includes the apparatus of any of Examples 1 to 2, wherein the logic is further to provide the host with an indication of a time interval for the host to initiate the subsequent wake-up in response to an information query from the host.
Example 4 includes the apparatus of Example 3, wherein the time interval corresponds to an amount of time after a removal of power to the persistent storage media.
Example 5 includes the apparatus of any of Examples 1 to 4, wherein the logic is further to provide a shutdown request to the host after the data management of the persistent storage media is performed.
Example 6 includes the apparatus of any of Examples 1 to 5, wherein the logic is further to remove power to the persistent storage media in response to a shutdown request from the host, and provide the host with an indication of a time interval for the host to initiate the subsequent wake-up in response to the shutdown request.
Example 7 includes the apparatus of any of Examples 1 to 6, wherein the persistent storage media comprises a solid state drive.
Example 8 includes an electronic system, comprising persistent storage media, and a controller communicatively coupled to the persistent storage media, the controller including logic to manage the persistent storage media, provide a host with an indication of a time for the host to initiate a subsequent wake-up for data management of the persistent storage media, and perform data management of the persistent storage media in response to a host-initiated wake-up from a zero power state.
Example 9 includes the system of Example 8, wherein the logic is further to provide the host with the indication of the time for the host to initiate the subsequent wake-up in response to the host-initiated wake-up from the zero power state.
Example 10 includes the system of any of Examples 8 to 9, wherein the logic is further to provide the host with an indication of a time interval for the host to initiate the subsequent wake-up in response to an information query from the host.
Example 11 includes the system of Example 10, wherein the time interval corresponds to an amount of time after a removal of power to the persistent storage media.
Example 12 includes the system of any of Examples 8 to 11, wherein the logic is further to provide a shutdown request to the host after the data management of the persistent storage media is performed.
Example 13 includes the system of any of Examples 8 to 12, wherein the logic is further to remove power to the persistent storage media in response to a shutdown request from the host, and provide the host with an indication of a time interval for the host to initiate the subsequent wake-up in response to the shutdown request.
Example 14 includes the system of any of Examples 8 to 13, wherein the persistent storage media comprises a solid state drive.
Example 15 includes a method of managing storage, comprising managing a persistent storage media, providing a host with an indication of a time for the host to initiate a subsequent wake-up for data management of the persistent storage media, and performing data management of the persistent storage media in response to a host-initiated wake-up from a zero power state.
Example 16 includes the method of Example 15, further comprising providing the host with the indication of the time for the host to initiate the subsequent wake-up in response to the host-initiated wake-up from the zero power state.
Example 17 includes the method of any of Examples 15 to 16, further comprising providing the host with an indication of a time interval for the host to initiate the subsequent wake-up in response to an information query from the host.
Example 18 includes the method of Example 17, wherein the time interval corresponds to an amount of time after a removal of power to the persistent storage media.
Example 19 includes the method of any of Examples 15 to 18, further comprising providing a shutdown request to the host after the data management of the persistent storage media is performed.
Example 20 includes the method of any of Examples 15 to 19, further comprising removing power to the persistent storage media in response to a shutdown request from the host, and providing the host with an indication of a time interval for the host to initiate the subsequent wake-up in response to the shutdown request.
Example 21 includes the method of any of Examples 15 to 20, wherein the persistent storage media comprises a solid state drive.
Example 22 includes at least one non-transitory one machine readable medium comprising a plurality of instructions that, in response to being executed on a computing device, cause the computing device to manage a persistent storage media, provide a host with an indication of a time for the host to initiate a subsequent wake-up for data management of the persistent storage media, and perform data management of the persistent storage media in response to a host-initiated wake-up from a zero power state.
Example 23 includes the at least one non-transitory one machine readable medium of Example 22, comprising a plurality of further instructions that, in response to being executed on the computing device, cause the computing device to provide the host with the indication of the time for the host to initiate the subsequent wake-up in response to the host-initiated wake-up from the zero power state.
Example 24 includes the at least one non-transitory one machine readable medium of any of Examples 22 to 23, comprising a plurality of further instructions that, in response to being executed on the computing device, cause the computing device to provide the host with an indication of a time interval for the host to initiate the subsequent wake-up in response to an information query from the host.
Example 25 includes the at least one non-transitory one machine readable medium of Example 24, wherein the time interval corresponds to an amount of time after a removal of power to the persistent storage media.
Example 26 includes the at least one non-transitory one machine readable medium of any of Examples 22 to 25, comprising a plurality of further instructions that, in response to being executed on the computing device, cause the computing device to provide a shutdown request to the host after the data management of the persistent storage media is performed.
Example 27 includes the at least one non-transitory one machine readable medium of any of Examples 22 to 26, comprising a plurality of further instructions that, in response to being executed on the computing device, cause the computing device to remove power to the persistent storage media in response to a shutdown request from the host, and provide the host with an indication of a time interval for the host to initiate the subsequent wake-up in response to the shutdown request.
Example 28 includes the at least one non-transitory one machine readable medium of any of Examples 22 to 27, wherein the persistent storage media comprises a solid state drive.
Example 29 includes a storage manager apparatus, comprising means for managing a persistent storage media, means for providing a host with an indication of a time for the host to initiate a subsequent wake-up for data management of the persistent storage media, and means for performing data management of the persistent storage media in response to a host-initiated wake-up from a zero power state.
Example 30 includes the apparatus of Example 29, further comprising means for providing the host with the indication of the time for the host to initiate the subsequent wake-up in response to the host-initiated wake-up from the zero power state.
Example 31 includes the apparatus of any of Examples 29 to 30, further comprising means for providing the host with an indication of a time interval for the host to initiate the subsequent wake-up in response to an information query from the host.
Example 32 includes the apparatus of Example 31, wherein the time interval corresponds to an amount of time after a removal of power to the persistent storage media.
Example 33 includes the apparatus of any of Examples 29 to 32, further comprising means for providing a shutdown request to the host after the data management of the persistent storage media is performed.
Example 34 includes the apparatus of any of Examples 29 to 33, further comprising means for removing power to the persistent storage media in response to a shutdown request from the host, and means for providing the host with an indication of a time interval for the host to initiate the subsequent wake-up in response to the shutdown request.
Example 35 includes the apparatus of any of Examples 29 to 34, wherein the persistent storage media comprises a solid state drive.

The term "coupled" may be used herein to refer to any type of relationship, direct or indirect, between the components in question, and may apply to electrical, mechanical, fluid, optical, electromagnetic, electromechanical or other connections. In addition, the terms "first", "second", etc. may be used herein only to facilitate discussion, and carry no particular temporal or chronological significance unless otherwise indicated.

As used in this application and in the claims, a list of items joined by the term "one or more of' may mean any combination of the listed terms. For example, the phrase "one or more of A, B, and C" and the phrase "one or more of A, B, or C" both may mean A; B; C; A and B; A and C; B and C; or A, B and C. Various components of the systems described herein may be implemented in software, firmware, and/or hardware and/or any combination thereof. For example, various components of the systems or devices discussed herein may be provided, at least in part, by hardware of a computing SoC such as may be found in a computing system such as, for example, a smart phone. Those skilled in the art may recognize that systems described herein may include additional components that have not been depicted in the corresponding figures. For example, the systems discussed herein may include additional components such as bit stream multiplexer or de-multiplexer modules and the like that have not been depicted in the interest of clarity.

While implementation of the example processes discussed herein may include the undertaking of all operations shown in the order illustrated, the present disclosure is not limited in this regard and, in various examples, implementation of the example processes herein may include only a subset of the operations shown, operations performed in a different order than illustrated, or additional operations.

In addition, any one or more of the operations discussed herein may be undertaken in response to instructions provided by one or more computer program products. Such program products may include signal bearing media providing instructions that, when executed by, for example, a processor, may provide the functionality described herein. The computer program products may be provided in any form of one or more machine-readable media. Thus, for example, a processor including one or more graphics processing unit(s) or processor core(s) may undertake one or more of the blocks of the example processes herein in response to program code and/or instructions or instruction sets conveyed to the processor by one or more machine-readable media. In general, a machine-readable medium may convey software in the form of program code and/or instructions or instruction sets that may cause any of the devices and/or systems described herein to implement at least portions of the operations discussed herein and/or any portions the devices, systems, or any module or component as discussed herein.

As used in any implementation described herein, the term "module" refers to any combination of software logic, firmware logic, hardware logic, and/or circuitry configured to provide the functionality described herein. The software may be embodied as a software package, code and/or instruction set or instructions, and "hardware", as used in any implementation described herein, may include, for example, singly or in any combination, hardwired circuitry, programmable circuitry, state machine circuitry, fixed function circuitry, execution unit circuitry, and/or firmware that stores instructions executed by programmable circuitry. The modules may, collectively or individually, be embodied as circuitry that forms part of a larger system, for example, an integrated circuit (IC), system on-chip (SoC), and so forth.

Various embodiments may be implemented using hardware elements, software elements, or a combination of both. Examples of hardware elements may include processors, microprocessors, circuits, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), logic gates, registers, semiconductor device, chips, microchips, chip sets, and so forth. Examples of software may include software components, programs, applications, computer programs, application programs, system programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. Determining whether an embodiment is implemented using hardware elements and/or software elements may vary in accordance with any number of factors, such as desired computational rate, power levels, heat tolerances, processing cycle budget, input data rates, output data rates, memory resources, data bus speeds and other design or performance constraints.

One or more aspects of at least one embodiment may be implemented by representative instructions stored on a machine-readable medium which represents various logic within the processor, which when read by a machine causes the machine to fabricate logic to perform the techniques described herein. Such representations, known as IP cores may be stored on a tangible, machine readable medium and supplied to various customers or manufacturing facilities to load into the fabrication machines that actually make the logic or processor.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

It will be recognized that the embodiments are not limited to the embodiments so described, but can be practiced with modification and alteration without departing from the scope of the appended claims. For example, the above embodiments may include specific combination of features. However, the above embodiments are not limited in this regard and, in various implementations, the above embodiments may include the undertaking only a subset of such features, undertaking a different order of such features, undertaking a different combination of such features, and/or undertaking additional features than those features explicitly listed. The scope of the embodiments should, therefore, be determined with reference to the appended claims, along with the full scope of equivalents to which such claims are entitled.

## Claims

1. An electronic apparatus, comprising:
one or more substrates; and
logic coupled to the one or more substrates, the logic to:
manage a persistent storage media,
provide a host with an indication of a time for the host to initiate a subsequent wake-up for data management of the persistent storage media, and
perform data management of the persistent storage media in response to a host-initiated wake-up from a zero power state.

2. The apparatus of claim 1, wherein the logic is further to:
provide the host with the indication of the time for the host to initiate the subsequent wake-up in response to the host-initiated wake-up from the zero power state.

3. The apparatus of any of claims 1 to 2, wherein the logic is further to:
provide the host with an indication of a time interval for the host to initiate the subsequent wake-up in response to an information query from the host.

4. The apparatus of claim 3, wherein the time interval corresponds to an amount of time after a removal of power to the persistent storage media.

5. The apparatus of any of claims 1 to 2, wherein the logic is further to:
provide a shutdown request to the host after the data management of the persistent storage media is performed.

6. An electronic system, comprising:
persistent storage media; and
a controller communicatively coupled to the persistent storage media, the controller including logic to:
manage the persistent storage media,
provide a host with an indication of a time for the host to initiate a subsequent wake-up for data management of the persistent storage media, and
perform data management of the persistent storage media in response to a host-initiated wake-up from a zero power state.

7. The system of claim 6, wherein the logic is further to:
provide the host with the indication of the time for the host to initiate the subsequent wake-up in response to the host-initiated wake-up from the zero power state.

8. The system of any of claims 6 to 7, wherein the logic is further to:
provide the host with an indication of a time interval for the host to initiate the subsequent wake-up in response to an information query from the host.

9. The system of claim 8, wherein the time interval corresponds to an amount of time after a removal of power to the persistent storage media.

10. The system of any of claims 6 to 7, wherein the logic is further to:
remove power to the persistent storage media in response to a shutdown request from the host; and
provide the host with an indication of a time interval for the host to initiate the subsequent wake-up in response to the shutdown request.

11. A method of managing storage, comprising:
managing a persistent storage media;
providing a host with an indication of a time for the host to initiate a subsequent wake-up for data management of the persistent storage media; and
performing data management of the persistent storage media in response to a host-initiated wake-up from a zero power state.

12. The method of claim 11, further comprising:
providing the host with the indication of the time for the host to initiate the subsequent wake-up in response to the host-initiated wake-up from the zero power state.

13. The method of any of claims 11 to 12, further comprising:
providing the host with an indication of a time interval for the host to initiate the subsequent wake-up in response to an information query from the host.

14. The method of any of claims 11 to 12, further comprising:
providing a shutdown request to the host after the data management of the persistent storage media is performed.

15. The method of any of claims 11 to 12, further comprising:
removing power to the persistent storage media in response to a shutdown request from the host; and
providing the host with an indication of a time interval for the host to initiate the subsequent wake-up in response to the shutdown request.
